# EUROPEAN PATENT SPECIFICATION

(11) **EP 1 544 913 B1**
(45) Date of publication and mention of the grant of the patent: **02.09.2015**
(21) Application number: 04029836.6
(22) Date of filing: 16.12.2004
(51) Int. Cl.: H01L 23/31

(54) **Semiconductor device and method of manufacturing thereof**
Halbleitervorrichtung und Verfahren zu ihrer Herstellung
Dispositif semi-conducteur et procédé pour sa fabrication

(30) Priority: 17.12.2003 JP 2003419406
(43) Date of publication of application: 22.06.2005
(60) Divisional application: 14192248.4
(73) Proprietor: Seiko Epson Corporation, Shinjuku-ku Tokyo 163-0811 (JP)
(72) Inventor: Ito, Haruki, Suwa-shi Nagano-ken 392-8502 (JP)
(74) Representative: Hoffmann Eitle

(56) References cited:
- EP-A1- 0 917 195
- JP-A- 2000 323 604
- JP-A- 2002 329 809
- US-A1- 2003 213 981
- US-B1- 6 396 148

## Description

### Technical Field

The present invention relates to a semiconductor device and a method of manufacturing thereof, a circuit substrate and an electronic apparatus. It relates, in particular, to a semiconductor device and a method of manufacturing thereof having highly reliable connections and circuit substrate and an electronic apparatus in which the semiconductor device is installed.

### Background of the invention

EP 0 917 195 A1 describes a semiconductor device capable of relieving thermal stress without breaking wire. It comprises a semiconductor chip, a solder ball for external connection, wiring for electrically connecting the semiconductor chip and the solder ball, a stress relieving layer provided on the semiconductor chip, and a stress transmission portion for transmitting stress from the solder ball to the stress relieving layer in a peripheral position of an electrical connection portion of the solder ball and wiring.

US 2003/0213981 A1 describes a semiconductor device with a package size close to its chip size which, apart from a stress absorbing layer, effectively absorbs thermal stresses. A semiconductor device has a semiconductor chip provided with electrodes, a resin layer forming a stress relieving layer provided, on the semiconductor chip, wiring formed from the electrodes to over the resin layer, and solder balls formed on the wiring over the resin layer; the resin layer is formed so as to have a depression in the surface, and the wiring is formed so as to pass over the depression.

In order to mounting a semiconductor device with high density, it is preferable to mount a semiconductor chip as it is without packaging such as bare mounting. In the bare chip mounting, however, it is insufficient to protect a semiconductor chip and hard to handle it.

Hence, a semiconductor device using a chip size package (CSP) is proposed and a wafer level CSP in which a diced wafer becomes a semiconductor device as it is recently developed. In this wafer level CSP, resin layers and wirings are formed on a surface of a silicon wafer in which tiny transistors are fabricated. This silicon wafer is cut into an individual semiconductor device so as to form a semiconductor device.

In the conventional method of manufacturing a semiconductor device using a wafer level CSP, when a resin layer is formed on a surface of a silicon wafer, a resin layer is not formed in a portion which is diced so as to avoid loosening of a resin layer and cracking of an end area of a semiconductor device.

### Published Prior Art

Other published prior art relating to the background of the invention is disclosed in the International Patent Publication No. WO-A-01-071805 document (e.g. FIG. 1 and FIG.14).

### Disclosure of the Invention

### Problem to Be Solved

In the conventional method of manufacturing a semiconductor device using a wafer level CSP, however, a resin layer and a external terminal are formed close to the center of a semiconductor element and the external terminal is connected to a wiring extended from an electrode formed in a circumference of the semiconductor device. In this case, there is a problem that a portion of a wiring connected to the external terminal is easily disconnected by as stress and others applied to a semiconductor device if the wiring is extended to the center direction of a semiconductor element from the electrode and directly connected to the external terminal. In particular, in case of wafer level CSP, a portion for forming the external terminal of a wiring (called a land) is large and the root of this land happens to be disconnected.

Further, in the conventional method of manufacturing a semiconductor device using a wafer level CSP, there is another problem that the root of the land formed in the a circumference of a semiconductor device is easily disconnected due to large stress at the far area from the center of a semiconductor device if a chip size becomes large. In the conventional method of manufacturing a semiconductor device, there is a further problem that a wiring is extended from the surface of a semiconductor device in which electrodes are formed to the surface of a resin layer so as to be a step in a wiring and it is hard to have fine wiring.

The present invention provides a semiconductor device as set out in Claim 1, a method of manufacturing a semiconductor device as set out in Claim 5 , a circuit substrate as set out in Claim 10, and an electronic apparatus as set out in Claim 11 . Optional features are set out in the remaining claims.

### Brief Description of the Drawings

In the drawings:
- **FIG. 1**: is an upper plan view and a longitudinal sectional view a first embodiment of the invention;
- **FIG. 2**: is an upper plan view and a longitudinal sectional view showing a semiconductor device in which the wiring having a structure of the first embodiment 1 is not used;
- **FIG. 3**: is an upper plan view of the process for manufacturing a semiconductor device of a second embodiment of the invention;
- **FIG. 4**: is an upper plan view showing a continued process followed by FIG.3 for manufacturing a semiconductor device;
- **FIG. 5**: is an upper plan view showing a continued process followed by FIG.4 for manufacturing a semiconductor device;
- **FIG. 6**: is a perspective view schematically showing an example of a circuit board according to a third embodiment of the invention; and
- **FIG. 7**: is an example of an electronic apparatus according to a third embodiment of the invention.

### Description of Preferred Embodiments

The following describes a semiconductor device, which can correspond to a large size chip and be provided with many external terminals with fine wiring with high reliable connection. Further, it is intended to provide a method of manufacturing the semiconductor device and a circuit substrate and an electronic apparatus in which the semiconductor device with highly reliable connections is installed.

A semiconductor device is described which comprises; a semiconductor element including a plurality of electrodes; a plurality of resin layers, a plurality of wirings electrically coupled to electrodes, and a plurality of external terminals electrically coupled to the wirings. A part of or all of the plurality of wirings comprises a first wiring directed to the center of the semiconductor element from a portion coupled to the electrodes; and a second wiring which is directed to an outer area from the center of the semiconductor element and coupled to the external terminals; and at least one resin layer is formed between the first wiring and the second wiring. A part of or all of the plurality of wirings comprises a first wiring directed to the center of the semiconductor element from a portion coupled to the electrodes and a second wiring which is directed to an outer area from the center of the semiconductor element and coupled to the external terminals so as to effectively relax the stress since a longitudinal section of the wiring is a shape. Further, a part of connecting the wiring to the external terminal is placed in the center of a semiconductor device so that disconnection of a part of connecting the wiring to the external terminal can be avoided even a stress is applied to the semiconductor device. Further, at least one resin layer is formed between the first wiring and the second wiring so as to relax a stress applied to the wiring and cope with large stress accompanied with large size chip. Further, the first wiring is not formed on a resin layer and no step is formed so as to enable fine wiring to be formed and many external terminals to be also formed.

In the semiconductor device, the semiconductor device is packaged with a chip size packaging method. There is a problem that a portion for connecting the wiring to the external terminal is disconnected described above when the semiconductor device is packaged with a CSP method. Hence, the above-described structure is applied to the wiring in the semiconductor device packaged with a CSP method so as to effectively avoid disconnection of the wiring.

The external terminal may be made of a solder ball. In the CSP semiconductor device, a solder ball is often used for the external terminal. A portion for forming the external terminal of a wiring (called a land) is large and the root of this land is happened to be disconnected and there is a problem of disconnecting the root of the land. However, the afore mentioned structure of the wiring can prevent the root of the land from disconnecting.

As also described below, a via hole is installed in at least of one resin layer so as to connect the first wiring and the second wiring. A via hole is installed, for example in at least of one resin layer formed between the first wiring and the second wiring so as to easily connect the first wiring to the second wiring and improve reliability of connection.

The semiconductor device may be manufactured by cutting the integration of semiconductor elements made of a silicon wafer with dicing. The semiconductor device is manufactured by cutting a silicon wafer in which tiny transistors and other are formed for example with dicing so that many semiconductor devices are obtained from a single silicon wafer.

At least one resin layer may be formed in a region excluding a portion cut with dicing. At least one resin layer may be formed in a region excluding cut portion with dicing the integration of semiconductor elements so as to avoid cracking of an end area of a semiconductor device and loosening of a resin layer.

Furthermore, at least one resin layer may be formed in a region in which the electrode is formed. The resin layer formed between the first wiring and the second wiring is also formed in a region in which the electrode is formed for example so that an area for forming external terminals can be expanded and many external terminals can be formed.

The following also describes a method of manufacturing a semiconductor device including; a semiconductor element including a plurality of electrodes; a plurality of resin layers, a plurality of wirings, and a plurality of external terminals connected to the wirings, the method of manufacturing semiconductor device comprises; forming a first wiring directed to the center of the semiconductor element from a portion coupled to the electrodes; forming at least a single resin layer; and forming a second wiring which is directed to outer area from the center of the semiconductor element and coupled to the external terminals. In a semiconductor element, a first wiring directed to the center of the semiconductor element from a portion coupled to the electrodes is formed, at least a one resin layer is formed thereafter and a second wiring which is directed to an outer area from the center of the semiconductor element and coupled to the first wiring and the external terminals so that a longitudinal section of the wiring is a shape to effectively relax the stress. Further, a part of connecting the wiring to the external terminal is placed in the center of a semiconductor device so that disconnection of a part of connecting the wiring to the external terminal can be avoided even if stress is applied to the semiconductor device. Further, at least one resin layer is formed between the first wiring and the second wiring so as to relax a stress applied to the wiring and cope with large stress accompanied with large size chip.

Further, the first wiring is not formed on a resin layer and no step is formed so as to enable fine wiring to be formed and many external terminals to be also formed.

In the method of manufacturing a semiconductor device, the semiconductor device may be packaged with a chip size packaging method.

There is a problem that a portion for connecting the wiring to the external terminal is disconnected described above when the semiconductor device is packaged with a CSP method. Hence, the above-described structure is applied to the wiring in the semiconductor device packaged with a CSP method so as to effectively avoid disconnection of the wiring.

In the method of manufacturing a semiconductor device, the external terminal may be made of a solder ball.

In the CSP semiconductor device, a solder ball is often used for the external terminal. A portion for forming the external terminal of a wiring (called a land) is large and the root of this land is happened to be disconnected and there is a problem of disconnecting the root of the land. However, the afore mentioned structure of the wiring can prevent the root of the land from disconnecting.

In the described method of manufacturing a semiconductor device, a via hole is installed in at least of one resin layer so as to connect the first wiring and the second wiring.

A via hole is installed, for example in at least of one resin layer formed between the first wiring and the second wiring so as to easily connect the first wiring to the second wiring and improve reliability of connection.

In the described method of a semiconductor device, the semiconductor device is manufactured by cutting the integration of semiconductor elements made of a silicon wafer during dicing.

The semiconductor device may be manufactured by cutting a silicon wafer in which tiny transistors and other are formed for example during dicing so that many semiconductor devices are obtained from a single silicon wafer.

In the described method of manufacturing a semiconductor device, at least one resin layer is formed in a region in which the electrode is formed.

The resin layer formed between the first wiring and the second wiring is also formed in a region in which the electrode is formed for example so that an area for forming external terminals can be expanded and many external terminals can be formed.

The above mentioned semiconductor device may be installed in a circuit board.

The electronic apparatus is provided with any of the above semiconductor devices so as to attain a high reliability connection.

In an electronic apparatus, any of the above mentioned semiconductor devices may be installed. The electronic apparatus may be provided with any of the above semiconductor devices so as to attain a high reliability connection.

### First Embodiment

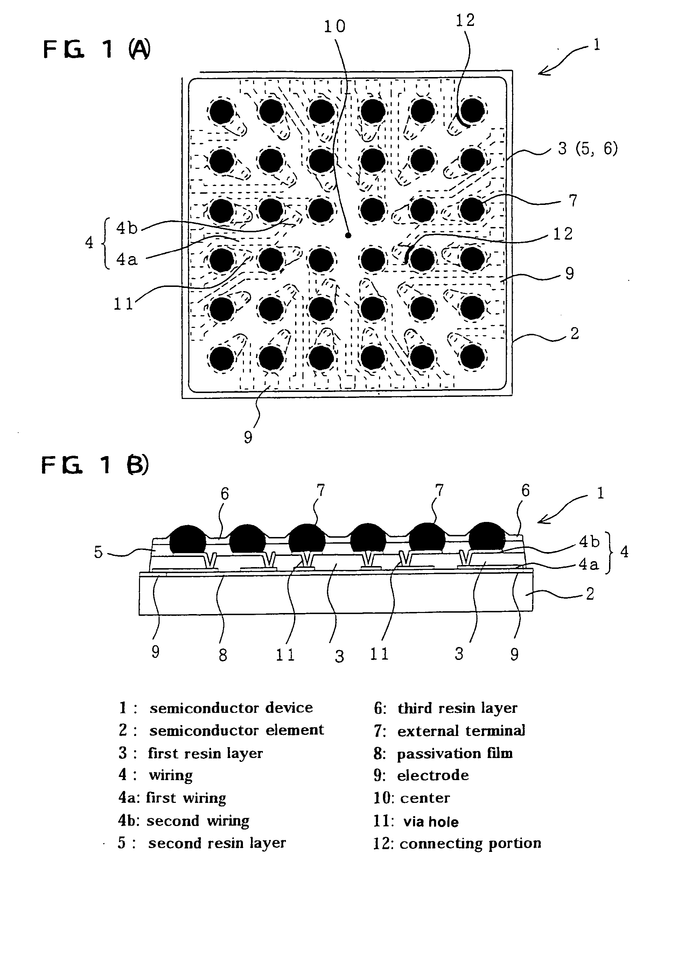

FIG. 1 is an upper plan view and a longitudinal sectional view of a first embodiment of the invention. Here, FIG IA is an example of the semiconductor device according to the embodiment 1 and some parts are shown transparent.

The semiconductor device 1 of the embodiment 1 mainly comprises a first resin layer 3, a wiring 4, a second resin layer 5, a third resin layer 6 and an external terminal 7 on one surface of a semiconductor element 2.

As shown in FIG.1, the wiring 4 comprises a first wiring 4a and a second wiring 4b. A resin layer 3 is formed between the first wiring 4a and the second wiring 4b. A passivation film 8 made of a insulation material and an electrode 9 are formed on one surface of the semiconductor element 2 and the first wiring 4a is formed on the surface of the passivation film 8. An electrode 9 and a wiring 4 are provided in a plurality of electrodes 9 and a plurality of wirings 4 which are electrically connected to each other. Namely, each of wirings 4 is provided with the external terminal 7 electrically coupled to the wirings 4 so as to electrically couple the external terminal 7 with the electrodes 9.

Here, in general, a second resin layer 5 is formed for protecting the wiring 4 and the external terminal 7. But, it is not necessarily needed. Further, in the embodiment 1, a third resin layer 6 is formed for reinforcing the root of the external terminal 7. But, it is not necessarily needed.

In the semiconductor element 2, many tiny transistors and others are formed by pre processing a silicon wafer. The first resin layer 3 and the external terminal 7 are formed on a silicon wafer and the silicon wafer is cut by dicing thereafter so as to form a semiconductor device 1. Thus, what a silicon wafer is diced into becomes a semiconductor device as it is. This is referred to as a wafer level CSP. The wafer level CSP is a kind of packaging method called CSP and further advanced as miniaturization compared to conventional CSP. Here, in the embodiment 1, silicon (mainly mono crystalline) is used as the semiconductor device 2. But other semiconductor materials such as Gallium Arsenide and others can be used.

A thin passivation film 8 and an electrode 9 made of Aluminum and others are formed on one surface of the semiconductor element 2 and the first wiring 4a and the first resin layer 3 are formed on the surface of the passivation film 8. In the embodiment 1, a plurality of electrodes 9 are placed in the circumference of the semiconductor element 2 and the first resin layer 3 is also formed on a part of electrodes 9. Thus, forming the first resin layer 3 can expand a region for forming the external terminal 7 and enables many external terminals 7 to be formed. Further, the first resin layer 3 is not formed at the outer circumstance of the semiconductor element 2. As the material for the first resin layer 3, polyimide resin, silicon denaturation of polyimide resin, epoxy resin, silicon denaturation of epoxy resin, phenolic resin, acrylic resin, benzocyclo butene (BCB) and poly benz oxazole(PBO) are used.

As described above, the wiring 4 comprises the first wiring 4a and the second wiring 4b. A resin layer 3 is formed between the first wiring 4a is formed on the surface of the passivation film 8 so as to be connected to electrodes 9 on the semiconductor element 2. The first wiring 4a is formed every electrodes 9 and an end for connecting electrodes 9 is a first land (explained in a second embodiment in detail) for coupling it to the second wiring 4b. The first wiring 4a is made of multi layers including a layer of an alloy of titanium and tungsten and a layer of copper. As shown in FIG.1A, the first wiring 4a is formed as directed to the center 10 of the semiconductor element 1 from a portion of connecting the first wiring 4a to the electrodes 9. Here, it is clear what is the center 10 in case of square shape of the semiconductor element 2 shown in FIG.1A. But, in case of a rectangular shape of the semiconductor element 2, it is located at the position, which divides a longitudinal direction and transverse direction into 50: 50. In case of other shapes, it is located at the gravitational center.

In the embodiment 1, the first wiring 4a is formed on the surface of the passivation film 8. It is preferable that other resin film is formed for example between the first wiring 4a and the semiconductor element 2.

The second wiring 4b is coupled to the first wiring 4a via the second via hole 11. In the embodiment 1, the second wiring 4b is formed on the surface of the first resin layer 3 and the first resin layer 3 is formed between the first wring 4a and the second wiring 4b. But, it is preferable that a plurality of resin layers are formed and other material is interposed between the first wiring 4a and the second wiring 4b. The second wiring 4b is connected to the external terminal 7 as directed to the outer area from the center 10 of the semiconductor element 2 and an end of a portion connected to the first wiring 4a is a second land (explained in a second embodiment in detail) for coupling it to the external terminal 7.

Here, in the first embodiment 1, the second wiring 4b connected to the external terminal 7 formed close to the center 10 of the semiconductor element 2, is not connected to the external terminal 7 as directed to outer area from the center 10 of the semiconductor element 2. Further, in the embodiment 1, as shown in FIG.B, the second wiring 4b is formed within the internal wall of the via hole. But, the first wiring 4a may be formed within the internal wall of the via hole.

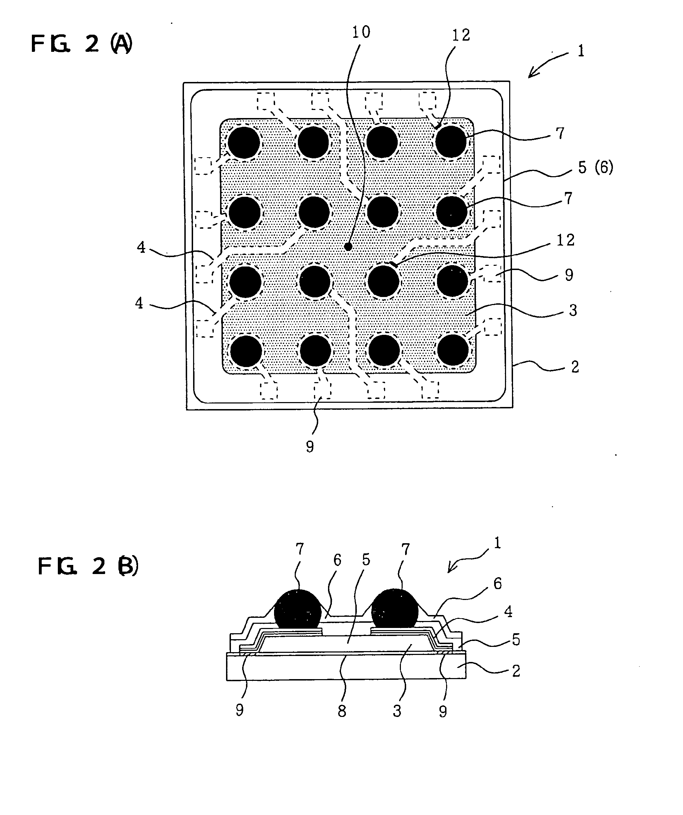

FIG.2 is a upper plan view and a longitudinal sectional view showing a semiconductor device in which the wiring having a structure of the first embodiment 1 is not used. Here, in FIG.2A, some parts are shown transparent similar to FIG IA. FIG.2B shows two external terminals 7 which are located in parallel each other for convenience and the same reference numbers in FIG. 1 are applied to the same portion in the Figure.

In the semiconductor device 1 shown in FIG.2, the wirings 4 comprises a single portion instead of two portions such as the first wiring 4a and the second wiring 4b. The wirings 4 are formed on the surface of the first resin layer 3 and extended toward the center 1 of the semiconductor element 2 from the electrode 9 and connected to the external terminal 7 as directed from the outer region to the center 10.

A large stress is applied to the semiconductor device 1 shown in FIG.1 and FIG.2 as moving far away from the center 10 due to warpage and others. As shown in FIG.2, the wirings 4 are connected to the external terminals 7 directed to the center 10 of the semiconductor element 2 from outside the external terminals 7 and connecting portions 12 of the wirings 4 are placed far from the center 10 so as to receive a large stress. Hence, in the conventional semiconductor device 1 shown in FIG.2, there is happened to be disconnected at the part of the connecting portion 12. Further, the wirings 4 connected to the external terminals 7 located far from the center has a short length so that the part of the connecting portion 12 is easily disconnected. Thus, in the semiconductor device 1 of the embodiment 1 (see FIG.1), the first wiring 4a and the second wiring 4b are formed and the second wiring 4b is connected to the external terminal 1 as directed to the outer area from the center 1 of the semiconductor element 2 so as to avoid disconnection of the connecting portion 12.

Here, the structure of the semiconductor device 1 according to the embodiment 1 shown in FIG.1B is reviewed. The second resin layer 5 is formed on the surface of the semiconductor element 2 comprising the first wiring 4a, the first resin layer 3 and the second wiring 4b. The second resin layer 5, however, is not formed in the outer circumstance of the semiconductor element 2 and a region (a second land explained in the embodiment 2 in detail) where the external terminal 7 of the second wiring 4b is formed. The second resin layer 5 is not formed in the outer circumstance of the semiconductor element 2, so as to avoid cracking of an end area of the semiconductor device 1 and loosening of a resin layer by avoiding the area cut with dicing when the semiconductor element 2 is cut from a silicon wafer with dicing. Here, as the material for the second resin layer 5, the same material for the first resin layer may be used or a different material thereof may be used.

The external terminal 7 made of a solder ball is formed on the second land 2 (explained in the second embodiment in detail) at the end of the second wiring 4b. The external terminal 7 is used for connecting the semiconductor device 1 to the circuit board and made of a lead-free solder for example.

Further, the third resin layer 6 may be formed on the surface of the second resin layer 5. The third resin layer 6 is formed mainly for reinforcing the external terminal 7 so that a circumferential area of the external terminal 7 rises like small hill. Further, the third resin layer 6 is formed exposing a part of the external terminal 7. Here, as the material for the third resin layer 6, the same material for the first resin layer 3 may be used or a different material thereof may be used.

It is preferable that each of elasticities of the first resin layer 3, the second resin layer 5 and the third resin layer 6 becomes lowered in this order. Thus, a resin layer having a lower elasticity from the semiconductor element 2 to the external element 7 is formed so as to effectively relax the stress such as warpage.

In the embodiment 1, a part of or all of the plurality of wirings 4 comprise the first wiring 4a directed to the center 11 of the semiconductor element 2 from a portion coupled to the electrodes 9 and the second wiring 4b which is directed to an outer area from the center 11 of the semiconductor element 2 and coupled to the external terminals 7 so as to make the longitudinal cross section of the wiring 4 a shape for relaxing a stress. Further, a part of connecting the second wiring 4b to the external terminals 7 is placed in the center of the semiconductor device 2 so that disconnection of a part connecting the second wiring 4b to the external terminals 7 can be avoided even a stress is applied to the semiconductor device 1. Further, the first resin layer 3 is formed between the first wiring 4a and the second wiring 4b so as to relax a stress applied to the wiring 4 and cope with large stress accompanied with a large size chip.

Further, the first wiring 4a is not formed on a resin layer and no step is formed so as to enable fine wiring to be formed and many external terminals 7 to be also formed.

### Second Embodiment

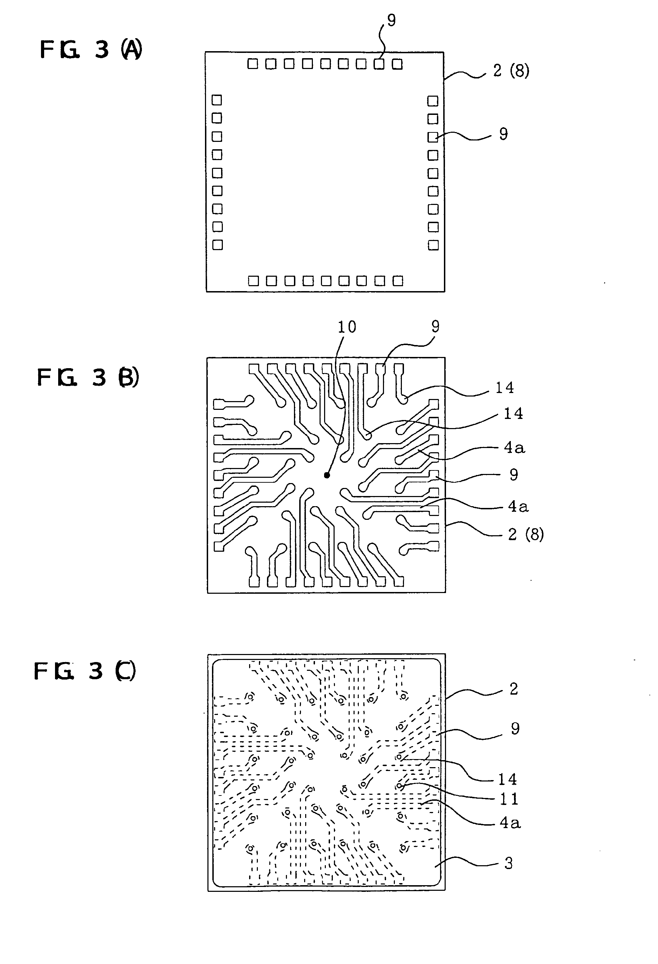

FIG. 3, 4 and 5 are a partial plan view and partial longitudinal cross section showing manufacturing process for a semiconductor device of the embodiment 2 of the invention.

Here, the manufacturing method shown in the embodiment 2 is to manufacture the semiconductor device 2 shown in the embodiment 1. In FIG.3, 4 and 5, the second resin layer 5, the third resin layer 6 are shown as see-through similar to FIG. 1A. FIG. 3, 4 and 5 show only a part corresponding to the semiconductor device 1 which is one of a silicon wafer as an integration of the semiconductor element 1.

First, the passivation film 8 and the electrodes 9 are formed on a silicon wafer provided with many tiny transistors via preprocessing (FIG.3A.) The passivation film 8 is formed in an area except a portion of electrodes 9 on a side surface of a semiconductor element 2. Electrodes 9 are formed in outer circumstance of the semiconductor element 2.

Then, a plurality of the first wirings 4a are formed as coupled to electrodes 9 on the semiconductor element 2. The first wiring 4a is formed as directed to the center 10 of the semiconductor element 2 from a portion of connecting the first wiring 4a to the electrodes 9. The end of the first wiring 4a is the first land 14 which will be coupled to the second wiring 4b later. By making the first land 14 relatively small, forming many external terminals 7 is possible so as to restrain disconnection of the root of the first land 14. The first wiring 4a is formed by forming an alloy layer of titanium and tungsten and a copper layer on the surface of the passivation film 8 with sputtering for example, coating a resist film with a predetermined shape (not shown) thereafter, leaving it in the area for the first wiring 4a with etching and removing the resist layer.

Further, the first resin layer 3 is formed on the surface of the passivation film 8 in which the wiring 4a has been formed during the process of FIG.3B (FIG.3C.) At this time, the first resin layer 3 is also formed on a part of the first wiring 4a and electrodes 9. Thus, forming the first resin layer 3 on a part of electrodes 9 can expand a region for forming the external terminals 7 and enables many external terminals 7 to be formed. A via hole 11 is formed in a part of the first land 14 of the resin layer 3 and the first wiring 4a can be coupled to electrodes 14 thereby.

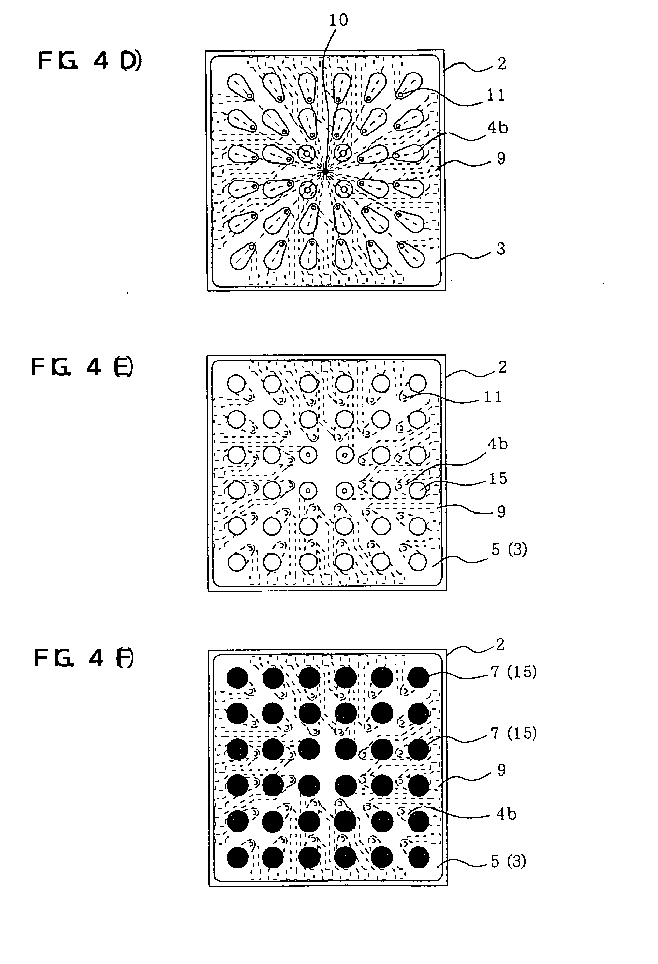

Further, the second wiring 4b is formed on the surface of the first resin layer 3 thereafter (FIG.4D.) The second wiring 4b is formed as to be connected to the first wiring 4a via the via hole 11 and directed to the outer area from the center 10 of the semiconductor element 2. The second wiring 4b is also formed by the same process for the first wiring 4a for example. But, it is preferable that copper plating is added over the layer of titanium and tungsten alloy and the copper layer.

The second resin layer 5 is formed on the surface of the first resin layer 3 and the second wiring 4b (FIG.4E.) At this time, the second resin layer 5 is not formed in the outer circumstance of the semiconductor element 2 as described above and an end of the second wiring 4b on the side of the via hole 11. The end of the second wiring 4b on the side of the via hole 11 is the second land 15 in which the external terminals 7 will be formed. The second land 15 is preferably formed having a larger area than that of the first land 14.

Further, the external terminals 7 made of a solder ball are formed in the second land 15 (FIG.4F.) The external terminal 7 is made of lead free solder for example and formed by a solder ball transferring, paste printing and plating.

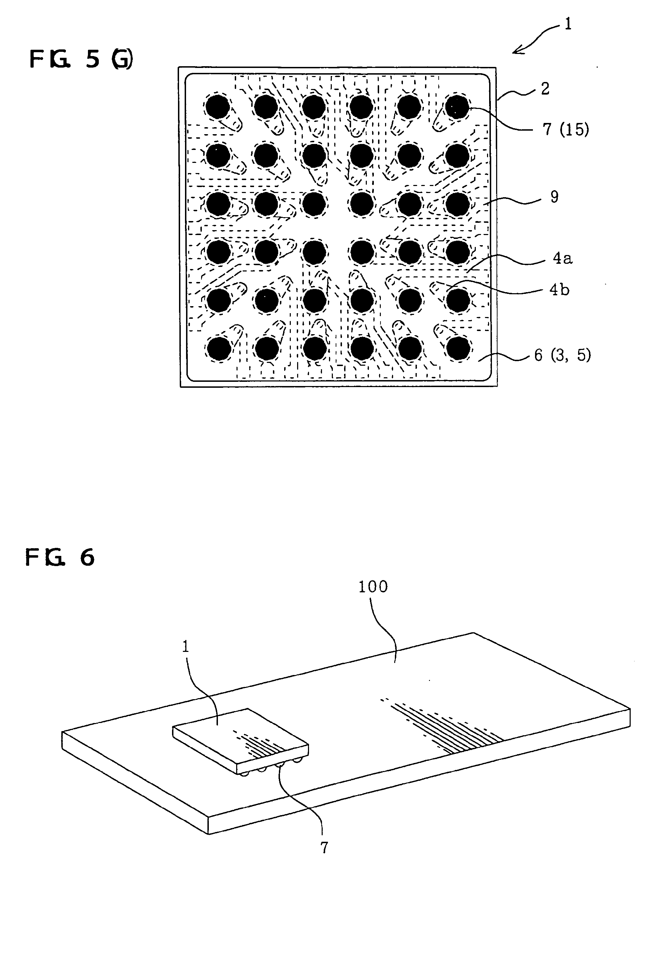

Further, the third resin layer 6 is formed on the surface of the second resin layer 5 (FIG.5G.) In this case, the third resin layer 6 is formed exposing a part of the external terminal 7. Further, the third resin layer 6 is not necessarily needed.

Finally, after completing the manufacturing processes shown in FIG.4F and through FIG. 5G, the silicon wafer is cut by dicing so as to form a individual semiconductor device 1. In the above manufacturing processes, the first resin layer 3 and the second resin layer 5 are not formed in the area in which a silicon wafer as integration of the semiconductor element 2 is diced so that these resin layers are not cut so as to avoid cracking the end of the semiconductor element 2 and removing off these resin layers.

In the embodiment 2, a part of or all of the plurality of wirings 4 comprise the first wiring 4a directed to the center 10 of the semiconductor element 2 from a portion coupled to the electrodes 9 and the second wiring 4b which is directed to an outer area from the center 10 of the semiconductor element 2 and coupled to the external terminals 7 so as to provide the longitudinal cross section of the wiring 4 with a shape for relaxing stress. Further, a part of connecting the second wiring 4b to the external terminals 7 is placed in the center of the semiconductor device 2 so that disconnection of a part connecting the second wiring 4b to the external terminals 7 can be avoided even if a stress is applied to the semiconductor device 1. Further, the first resin layer 3 is formed between the first wiring 4a and the second wiring 4b so as to relax a stress applied to the wiring 4 and cope with large stress accompanied with a large size chip.

Other advantages in the embodiment are the same in the semiconductor device according to the first embodiment.

### Third Embodiment

FIG. 6 is a perspective view schematically showing an example of a circuit board according to a third embodiment of the invention. In a circuit board 100 shown in FIG. 6, the semiconductor device according to the first embodiment of the invention is mounted. The circuit board 100 is made of a glass epoxy substrate and wiring patterns such as copper and others are formed in advance. The external terminal 7 of the semiconductor device 1 is connected to the circuit board 100 so as to be electrically conducted and perform a predetermined processing (data processing for example).

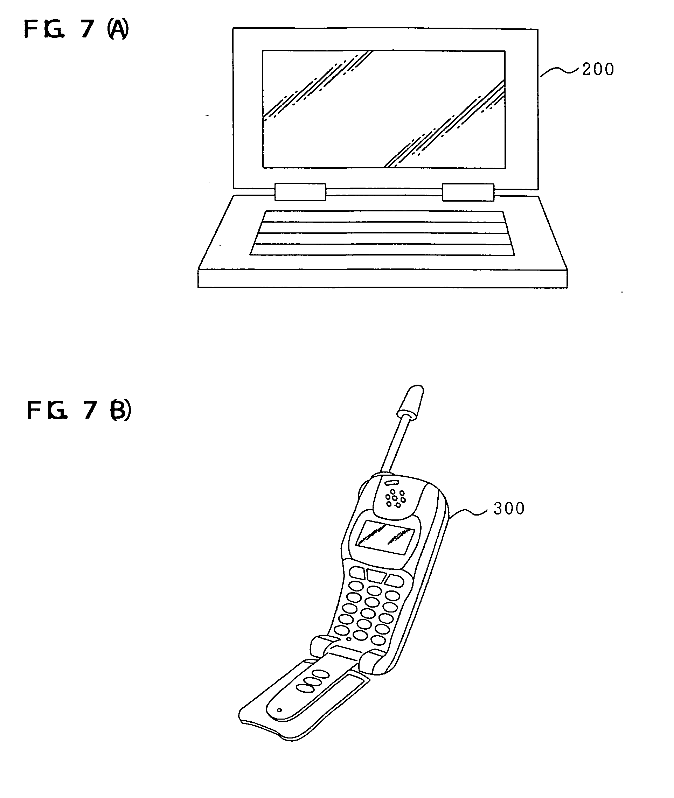

FIG. 7 is an example of an electronic apparatus according to a third embodiment of the invention. An electronic apparatus shown in FIG. 7, has the semiconductor device 1 according to the first embodiment of the invention. FIG.7A shows an example in which the semiconductor device 1 is applied to the personal computer 200 and FIG.7B is an example in which the semiconductor device 1 is applied to the cellar phone 300. Here, the semiconductor device 1 shown in the first embodiment 1 and the semiconductor device 1 shown the manufacturing method of the second embodiment 2 can be applied to other electronic devices for home use.

### List of Reference Numerals

1; A semiconductor device,
2; semiconductor element,
3; first resin layer,
4; wiring,
4a; first wiring,
4b; second wiring,
5; second resin layer,
6; third resin layer,
7; external terminal,
8; passivation film,
9; electrode,
10; center,
11; via hole,
12; connecting portion,
14; first land,
15; second land.

## Claims

1. A semiconductor device (1) comprising:
a semiconductor substrate (2) having a plurality of electrodes (9) provided on a circumferential region of a first major surface thereof;
a plurality of wirings (4a, 4b) electrically coupled to the electrodes, and a plurality of external terminals (7) coupled to respective ones of the wirings, wherein the wirings comprise first wirings (4a) and second wirings (4b), and wherein each first wiring (4a) is provided on an insulation film (8) on the first major surface, each first wiring (4a) having a first end connected to a respective one of the electrodes (9), a second end, and a first land (14) at the second end, the first wirings (4a) being directed to the centre (10) of the first major surface from the respective first ends; and
a resin layer (3) provided on said first wirings (4a) and comprising a plurality of via holes (11) exposing respective ones of the first lands (14), wherein each second wiring (4b) is provided on said resin layer (3) and has a first end connected to a respective one of the first lands (14) of the first wiring (4a), and has a second end comprising a second land (15), and wherein each of the external terminals (7) is formed on a respective one of the second lands (15) of the second wirings (4b),
**characterised by** each second wiring (4b) being directed from its first end to its second end towards an outer area of the first major surface from the centre of the first major surface.

2. A semiconductor device according to claim 1, further comprising:
a second resin layer (5) formed on the surface of the first resin layer (3) and the second wiring (4b) for protecting the wirings and
the terminals; and
a third resin layer (6) formed on the surface of the second resin layer (5) for reinforcing the roots of the terminals.

3. A semiconductor device according to any of claims 1 or 2 wherein the external terminals (7) are solder balls.

4. A semiconductor device according to any preceding claim, wherein the resin layer (3) is not formed around the periphery of the substrate.

5. A method of manufacturing a semiconductor device comprising: a semiconductor substrate (1) having a plurality of electrodes (9) provided on a circumferential region of a first major surface of the substrate (2); a resin layer (3); a plurality of wirings (4a, 4b) electrically coupled to the electrodes, and a plurality of external terminals (7) coupled to the wirings,
the method of manufacturing the semiconductor device comprising:
forming a plurality of first wirings (4a) on an insulation film (8) on the first major surface, each first wiring having a first end connected to a respective one of the electrodes (9), a second end, and a first land (14) at the second end, each first wiring being directed from its first end to its second end towards the centre of the first major surface;
forming a resin layer (3) on said first wirings (4a)
and forming a plurality of via holes (11) exposing respective ones of the first lands(14);
forming a plurality of second wirings (4b) on said resin layer (3), each second wiring having a first end connected to a respective first land (14) of the first wiring (4a) and having a second end comprising a second land (15); and
forming each of the external terminals (7) on a respective one of the second lands (15) of the second wirings (4b),
**characterised in that** each second wiring is formed so as to be directed from its first end to its second end towards an outer area of the first major surface from the centre thereof.

6. A method of manufacturing a semiconductor device according to claim 5 , wherein the external terminals (7) are solder balls.

7. A method of manufacturing a semiconductor device according to any of claims 5 or 6 , further comprising:
manufacturing the semiconductor device by dicing a silicon wafer containing a plurality of the semiconductor substrates.

8. A method of manufacturing a semiconductor device according to any of claims 5 to 7 , further comprising:
forming a second resin layer (5) for protecting the wirings and the terminals; and
forming a third resin layer (6) for reinforcing the roots of the terminals.

9. A method of manufacturing a semiconductor device according to any of claims 7 or 8 , wherein the resin layer (3) is not formed in regions to be cut during dicing of the wafer.

10. A circuit substrate including the semiconductor device according to any of claims 1 to 4.

11. An electronic apparatus including the semiconductor device according to any of claims 1 to 4.

## Patentansprüche

1. Eine Halbleitervorrichtung (1), umfassend:
ein Halbleiterträgermaterial (2) mit einer Vielzahl von Elektroden (9), welche auf einem Umfangsbereich einer ersten Hauptoberfläche davon vorgesehen sind;
eine Vielzahl von elektrisch mit den Elektroden gekoppelten Leitungen (4a, 4b) und eine Vielzahl von mit entsprechenden der Leitungen gekoppelten externen Anschlüssen (7), wobei die Leitungen erste Leitungen (4a) und zweite Leitungen (4b) umfassen, und wobei jede erste Leitung (4a) auf einem Isolationsfilm (8) auf der ersten Hauptoberfläche vorgesehen ist, wobei jede erste Leitung (4a) ein mit einer entsprechenden der Elektroden (9) verbundenes erstes Ende, ein zweites Ende und eine erste Anschlussfläche (14) an dem zweiten Ende aufweist, wobei die ersten Leitungen (4a) zu dem Zentrum (10) der ersten Hauptoberfläche von den entsprechenden ersten Enden gerichtet sind; und
wobei eine Harzschicht (3) auf den ersten Leitungen (4a) vorgesehen ist und eine Vielzahl von Durchgangslöchern (11) umfasst, welche entsprechende der ersten Anschlussflächen (14) freilegen, wobei jede zweite Leitung (4b) auf der Harzschicht (3) vorgesehen ist und ein mit einer entsprechenden der ersten Anschlussflächen (14) der ersten Leitung (4a) verbundenes erstes Ende aufweist, und ein eine zweite Anschlussfläche aufweisendes zweites Ende (15) aufweist, und wobei jede der externen Anschlüsse (7) auf einer entsprechenden der zweiten Anschlussflächen (15) der zweiten Leitungen (4b) gebildet ist,
**gekennzeichnet dadurch, dass** jede zweite Leitung (4b) von dessen erstem Ende zu dessen zweitem Ende in einen äußeren Bereich der ersten Hauptoberfläche von dem Zentrum der ersten Hauptoberfläche gerichtet ist.

2. Halbleitervorrichtung gemäß Anspruch 1, weiter umfassend:
eine zweite Harzschicht (5), welche auf der Oberfläche der ersten Harzschicht (3) und der zweiten Leitung (4b) gebildet ist, zum Schützen der Leitungen und der Anschlüsse; und
eine dritte Harzschicht (6), auf der Oberfläche der zweiten Harzschicht (5) ausgebildet, zum Verstärken der Wurzeln der Anschlüsse.

3. Halbleitervorrichtung gemäß einem der Ansprüche 1 oder 2, wobei die externen Anschlüsse (7) Lötkugeln sind.

4. Halbleitervorrichtung gemäß einem der vorstehenden Ansprüche, wobei die Harzschicht (3) nicht um die Peripherie des Trägermaterials herum gebildet ist.

5. Ein Verfahren zum Herstellen einer Halbleitervorrichtung umfassend: ein Halbleiterträgermaterial (1) mit einer Vielzahl von Elektroden (9), welche auf einem Umfangsbereich einer ersten Hauptoberfläche des Trägermaterials (2) gebildet sind; eine Harzschicht (3); eine Vielzahl von mit den Elektroden elektrisch gekoppelter Leitungen (4a, 4b) und eine Vielzahl von mit den Leitungen gekoppelten externen Anschlüssen (7), wobei das Verfahren zum Herstellen der Halbleitervorrichtung umfasst:
Bilden einer Vielzahl von ersten Leitungen (4a) auf einem Isolationsfilm (8) auf der ersten Hauptoberfläche, wobei jede erste Leitung ein mit einer entsprechenden der Elektroden (9) verbundenes erstes Ende, ein zweites Ende und eine erste Anschlussfläche (14) an dem zweiten Ende umfasst, wobei jede erste Leitung von dessen erstem Ende zu dessen zweitem Ende in das Zentrum der ersten Hauptoberfläche gerichtet ist;
Bilden einer Harzschicht (3) auf den ersten Leitungen (4a) und Bilden einer Vielzahl von Durchbruchslöchern (11), welche entsprechende der ersten Anschlussflächen (14) freilegen;
Bilden einer Vielzahl von zweiten Leitungen (4b) auf der Harzschicht (3), wobei jede der zweiten Leitungen ein mit einer entsprechenden ersten Anschlussfläche (14) der ersten Leitung (4 a) verbundenes erstes Ende aufweist und ein eine zweite Anschlussfläche (15) umfassendes zweites Ende aufweist; und
Bilden eines jeden der externen Anschlüsse (7) auf entsprechenden der zweiten Anschlussflächen (15) der zweiten Leitungen (4b),
**dadurch gekennzeichnet, dass** jede zweite Leitung so ausgebildet ist, um von dessen erstem Ende zu dessen zweitem Ende in einen äußeren Bereich der ersten Hauptoberfläche von dem Zentrum davon gerichtet zu sein.

6. Verfahren zum Herstellen einer Halbleitervorrichtung gemäß Anspruch 5, wobei die externen Anschlüsse (7) Lötkugeln sind.

7. Verfahren zum Herstellen einer Halbleitervorrichtung gemäß einem der Ansprüche 5 oder 6, weiter umfassend:
Herstellen der Halbleitervorrichtung durch Würfeln eines Siliziumwafers, welcher eine Vielzahl der Halbleiterträgermaterialen enthält.

8. Verfahren zum Herstellen einer Halbleitervorrichtung gemäß einem der Ansprüche 5 bis 7, weiter umfassend:
Bilden einer zweiten Harzschicht (5) zum Schützen der Leitungen und der Anschlüsse; und
Bilden einer dritten Harzschicht (6) zum Verstärken der Wurzeln der Anschlüsse.

9. Verfahren zum Herstellen einer Halbleitervorrichtung gemäß einem der Ansprüche 7 oder 8, wobei die Harzschicht (3) nicht in während dem Würfeln des Wafers zu schneidenden Bereichen gebildet wird.

10. Ein Schaltkreisträgermaterial, umfassend die Halbleitervorrichtung gemäß einem der Ansprüche 1 bis 4.

11. Eine elektronische Vorrichtung, umfassend die Halbleitervorrichtung gemäß einem der Ansprüche 1 bis 4.

## Revendications

1. Dispositif à semi-conducteur (1) comprenant :
un substrat semi-conducteur (2) ayant une pluralité d'électrodes (9) prévues sur une région circonférentielle d'une première surface principale de celui-ci ;
une pluralité de câblages (4a, 4b) électriquement couplés aux électrodes et une pluralité de bornes externes (7) couplées à des câblages respectifs parmi les câblages, où les câblages comprennent des premiers câblages (4a) et deuxièmes câblages (4b), et où chaque premier câblage (4a) est prévu sur un film isolant (8) sur la première surface principale, chaque premier câblage (4a) ayant une première extrémité reliée à une électrode respective parmi les électrodes (9), une deuxième extrémité et une première pastille (14) au niveau de la deuxième extrémité, les premiers câblages (4a) étant dirigés vers le centre (10) de la première surface principale à partir des premières extrémités respectives ; et
une couche de résine (3) prévue sur lesdits premiers câblages (4a) et comprenant une pluralité de trous traversants (11) exposant des pastilles respectives parmi les premières pastilles (14), où chaque deuxième câblage (4b) est prévu sur ladite couche de résine (3) et a une première extrémité reliée à une pastille respective parmi les premières pastilles (14) du premier câblage (4a), et a une deuxième extrémité comprenant une deuxième pastille (15), et où chacune des bornes externes (7) est formée sur une pastille respective parmi les deuxièmes pastilles (15) des deuxièmes câblages (4b),
**caractérisé en ce que** chaque deuxième câblage (4b) étant dirigé à partir de sa première extrémité jusqu'à sa deuxième extrémité vers une zone extérieure de la première surface principale à partir du centre de la première surface principale.

2. Dispositif à semi-conducteur selon la revendication 1, comprenant en outre :
une deuxième couche de résine (5) formée sur la surface de la première couche de résine (3) et le deuxième câblage (4b) pour protéger les câblages et les bornes ; et
une troisième couche de résine (6) formée sur la surface de la deuxième couche de résine (5) pour renforcer les embases des bornes.

3. Dispositif à semi-conducteur selon l'une des revendications 1 ou 2, dans lequel les bornes externes (7) sont des billes de soudure.

4. Dispositif à semi-conducteur selon l'une des revendications précédentes, dans lequel la couche de résine (3) n'est pas formée autour de la périphérie du substrat.

5. Procédé de fabrication d'un dispositif à semi-conducteur comprenant : un substrat semi-conducteur (1) ayant une pluralité d'électrodes (9) prévues sur une région circonférentielle d'une première surface principale du substrat (2) ; une couche de résine (3) ; une pluralité de câblages (4a, 4b) électriquement couplés aux électrodes, et une pluralité de bornes externes (7) couplées aux câblages,
le procédé de fabrication du dispositif à semi-conducteur comprenant le fait :
de former une pluralité de premiers câblages (4a) sur un film isolant (8) sur la première surface principale, chaque premier câblage ayant une première extrémité reliée à une électrode respective parmi les électrodes (9), une deuxième extrémité et une première pastille (14) au niveau de la deuxième extrémité, chaque premier câblage étant dirigé à partir de sa première extrémité jusqu'à sa deuxième extrémité vers le centre de la première surface principale ;
de former une couche de résine (3) sur lesdits premiers câblages (4a) et de former une pluralité de trous traversants (11) exposant des pastilles respectives parmi les premières pastilles (14) ;
de former une pluralité de deuxièmes câblages (4b) sur ladite couche de résine (3), chaque deuxième câblage ayant une première extrémité reliée à une première pastille respective (14) du premier câblage (4a) et ayant une deuxième extrémité comprenant une deuxième pastille (15) ; et
de former chacune des bornes externes (7) sur une pastille respective parmi les deuxièmes pastilles (15) des deuxièmes câblages (4b),
**caractérisé en ce que** chaque deuxième câblage est formé de manière à être dirigé à partir de sa première extrémité jusqu'à sa deuxième extrémité vers une zone extérieure de la première surface principale à partir du centre de celle-ci.

6. Procédé de fabrication d'un dispositif à semi-conducteur selon la revendication 5, dans lequel les bornes externes (7) sont des billes de soudure.

7. Procédé de fabrication d'un dispositif à semi-conducteur selon l'une des revendications 5 ou 6, comprenant en outre le fait :
de fabriquer le dispositif à semi-conducteur par découpage en dès d'une tranche de silicium contenant une pluralité de substrats semi-conducteurs.

8. Procédé de fabrication d'un dispositif à semi-conducteur selon l'une des revendications 5 à 7, comprenant en outre le fait :
de former une deuxième couche de résine (5) pour protéger les câblages et les bornes ; et
de former une troisième couche de résine (6) pour renforcer les embases des bornes.

9. Procédé de fabrication d'un dispositif à semi-conducteur selon l'une des revendications 7 ou 8, dans lequel la couche de résine (3) n'est pas formée dans des régions à découper au cours du découpage en dès de la tranche.

10. Substrat de circuit comportant le dispositif à semi-conducteur selon l'une des revendications 1 à 4.

11. Appareil électronique comportant le dispositif à semi-conducteur selon l'une des revendications 1 à 4.
